# EUROPEAN PATENT APPLICATION

(11) **EP 2 600 526 A2**
(43) Date of publication of application: **05.06.2013**
(21) Application number: 12162391.2
(22) Date of filing: 30.03.2012
(51) Int. Cl.: H03K 5/05

(54) **Image forming apparatus, signal outputting apparatus and signal outputting method**

(30) Priority: 30.11.2011 KR 20110127064
(71) Applicant: Samsung Electronics Co., Ltd., Suwon-si, Gyeonggi-do, 443-742 (KR)
(72) Inventor: Shim, Wook-jin, Gyeonggi-do (KR); Kim, Youn-jae, Gyeonggi-do (KR)
(74) Representative: Taor, Simon Edward William

(57) **Abstract**

An image forming apparatus includes a function unit to perform one or more functions of the image forming apparatus; and a control unit (200) to control the function unit to perform the functions of the image forming apparatus, wherein the control unit (200) includes: a first signal generator (210) to generate a first signal comprising a control signal to control the function unit; a second signal generator (220) to generate a second signal comprising a pulse signal with a predetermined high frequency; a synthesizer (230) to generate a third signal by synthesizing the first signal and the second signal during an edge period of the first signal; and an outputter (240) to output the third signal.

## Description

The present invention generally relates to an image forming apparatus, a signal outputting apparatus, and a signal outputting method, and more particularly, to an image forming apparatus, a signal outputting apparatus, and a signal outputting method, which can improve electromagnetic interference (EMI) properties by adding a high-frequency pulse signal to a low-frequency signal during an edge period of the low-frequency signal.

Image forming apparatuses are devices that print data generated by a terminal device such as a computer, etc, onto a recording medium. Examples of image forming apparatuses include a copier, a printer, a facsimile machine, a multi-functional peripheral (MFP) into which the functions of a copier, a printer, and a facsimile machine are incorporated, and the like.

An image forming apparatus may include a controller to control various function units in the image forming apparatus. The controller may transmit control signals to the various function units and may thus control the various function units. The control signals may include a high-frequency signal with a frequency of higher than several tens of kHz and a low-frequency signal with a frequency of lower than several tens of kHz to control a power source and a motor.

The image forming apparatus is a type of electronic device and is thus required to meet certain electromagnetic interference (EMI) requirements. To do so, a high-capacitance capacitor and a high-resistance resistor may be used at the output terminal of a controller that outputs a low-frequency signal.

More specifically, since the slew rate of a low-frequency signal considerably affects the EMI properties of the image forming apparatus, a high-capacitance capacitor and a high-resistance resistor may be used at the output terminal of the controller that outputs the low-frequency signal to reduce the slew rate of the low-frequency signal.

However, there is a clear limit in reducing the slew rate of the low-frequency signal simply with the use of a resistor and a capacitor. In addition, due to the use of a high-capacitance capacitor and a high-resistance resistor, it is difficult to reduce the size of a printed circuit board (PCB).

Additional aspects and/or advantages will be set forth in part in the description which follows and, in part, will be apparent from the description, or may be learned by practice of the invention.

Exemplary embodiments address at least the above problems and/or disadvantages and other disadvantages not described above. Also, the exemplary embodiments are not required to overcome the disadvantages described above, and an exemplary embodiment may not overcome any of the problems described above.

The exemplary embodiments include an image forming apparatus and a signal outputting apparatus and a signal outputting method, which can improve the electromagnetic interference (EMI) properties of the image forming apparatus by adding a high-frequency pulse signal to a low-frequency signal during an edge period of the low-frequency signal.

According to an aspect of the exemplary embodiments, there is provided an image forming apparatus including: a function unit to perform one or more functions of the image forming apparatus; and a control unit to control the function unit to perform the functions of the image forming apparatus, the control unit includes: a first signal generator to generate a first signal including a control signal to control the function unit; a second signal generator to generate a second signal including a pulse signal with a predetermined high frequency; a synthesizer to generate a third signal by synthesizing the first signal and the second signal during an edge period of the first signal; and an outputter to output the third signal.

The first signal may include at least one of a pulse width modulation (PWM) signal and a clock signal.

The first signal may have frequency properties and a frequency of the first signal may be lower than the frequency of the second signal.

The outputter may be connected to at least one of a resistor-capacitor (RC) filter and a capacitor-resistor (CR) filter.

The edge period of the first signal may include a period that begins from at least one of a rising edge and a falling edge of the first signal and lasts for a predetermined amount of time.

The edge period of the first signal may include a period that begins a predetermined amount of time before at least one of a rising edge and a falling edge of the first signal and ends at the at least one of the rising edge and the falling edge of the first signal.

The edge period of the first signal may include a period that begins a predetermined amount of time before a rising edge of the first signal and ends at the rising edge of the first signal and a period that begins from a falling edge of the first signal and lasts for the predetermined amount of time.

The edge period of the first signal may include a period that begins from a rising edge of the first signal and lasts for a predetermined amount of time and a period that begins the predetermined amount of time before a falling edge of the first signal and ends at the falling edge of the first signal.

The synthesizer may perform a logic OR operation on the first signal and the second signal during the edge period of the first signal and may perform a logic AND operation on the first signal and the second signal during a non-edge period of the first signal.

A slew rate of the third signal may be higher than a slew rate of the first signal.

According to another aspect of the exemplary embodiments, there is provided a signal outputting apparatus including: a first signal generator to generate a first signal that is a control signal; a second signal generator to generate a second signal that is a pulse signal with a predetermined high frequency; a synthesizer to generate a third signal by synthesizing the first signal and the second signal during an edge period of the first signal; and an outputter which outputs the third signal.

The first signal may include at least one of a PWM signal and a clock signal.

The first signal may have frequency properties and a frequency of the first signal may be lower than the frequency of the second signal.

The edge period of the first signal may include a period that begins from at least one of a rising edge and a falling edge of the first signal and lasts for a predetermined amount of time.

The edge period of the first signal may include a period that begins a predetermined amount of time before at least one of a rising edge and a falling edge of the first signal and ends at the at least one of the rising edge and the falling edge of the first signal.

The edge period of the first signal may include a period that begins a predetermined amount of time before a rising edge of the first signal and ends at the rising edge of the first signal and a period that begins from a falling edge of the first signal and lasts for the predetermined amount of time.

The edge period of the first signal may include a period that begins from a rising edge of the first signal and lasts for a predetermined amount of time and a period that begins the predetermined amount of time before a falling edge of the first signal and ends at the falling edge of the first signal.

The second signal generator may generate a pulse signal whose duty rate varies.

The second signal generator may generate a pulse signal whose duty rate increases closer to the edge period of the first signal.

The synthesizer may perform a logic OR operation on the first signal and the second signal during the edge period of the first signal and may perform a logic AND operation on the first signal and the second signal during a non-edge period of the first signal.

A slew rate of the third signal may be higher than a slew rate of the first signal.

According to another aspect of the exemplary embodiments, there is provided a signal outputting method including: generating a first signal including a control signal; generating a second signal including a pulse signal with a predetermined high frequency; generating a third signal by synthesizing the first signal and the second signal during an edge period of the first signal; and outputting the third signal.

The first signal may include at least one of a PWM signal and a clock signal.

The first signal may have frequency properties and a frequency of the first signal may be lower than the frequency of the second signal.

The edge period of the first signal may include a period that begins from at least one of a rising edge and a falling edge of the first signal and lasts for a predetermined amount of time.

The edge period of the first signal may include a period that begins a predetermined amount of time before at least one of a rising edge and a falling edge of the first signal and ends at the at least one of the rising edge and the falling edge of the first signal.

The edge period of the first signal may include a period that begins a predetermined amount of time before a rising edge of the first signal and ends at the rising edge of the first signal and a period that begins from a falling edge of the first signal and lasts for the predetermined amount of time.

The edge period of the first signal may include a period that begins from a rising edge of the first signal and lasts for a predetermined amount of time and a period that begins the predetermined amount of time before a falling edge of the first signal and ends at the falling edge of the first signal.

The generating the second signal may include generating a pulse signal whose duty rate increases closer to the edge period of the first signal.

The generating the third signal may include performing a logic OR operation on the first signal and the second signal during the edge period of the first signal and performing a logic AND operation on the first signal and the second signal during a non-edge period of the first signal.

A slew rate of the third signal may be higher than a slew rate of the first signal.

The above and/or other aspects will be more apparent by describing certain exemplary embodiments with reference to the accompanying drawings, in which:
FIG. 1 is a block diagram illustrating an image forming apparatus according to an exemplary embodiment;
FIG. 2 is a block diagram illustrating an example of a control unit illustrated in FIG. 1, according to an exemplary embodiment;
FIG. 3 is a circuit diagram illustrating an example of the control unit illustrated in FIG. 1, according to an exemplary embodiment;
FIGS. 4 and 5 are diagrams illustrating an example of information that may be input to/output from first and second signal generation units illustrated in FIG. 2, according to an exemplary embodiment;
FIGS. 6 to 8 are diagrams illustrating various examples of an output signal of a signal outputting apparatus according to an exemplary embodiment;
FIGS. 9 and 10 are diagrams illustrating an example of the slew rate of an output signal of a signal outputting apparatus according to an exemplary embodiment; and
FIG. 11 is a flowchart illustrating a signal output method according to an exemplary embodiment.

Reference will now be made in detail to the embodiments, examples of which are illustrated in the accompanying drawings, wherein like reference numerals refer to the like elements throughout. The embodiments are described below to explain the present invention by referring to the figures.

Exemplary embodiments are described in greater detail with reference to the accompanying drawings.

In the following description, the same drawing reference numerals are used for the same elements even in different drawings. The matters defined in the description, such as detailed construction and elements, are provided to assist in a comprehensive understanding of the exemplary embodiments. Thus, it is apparent that the exemplary embodiments can be carried out without those specifically defined matters. Also, well-known functions or constructions are not described in detail since they would obscure the exemplary embodiments with unnecessary detail.

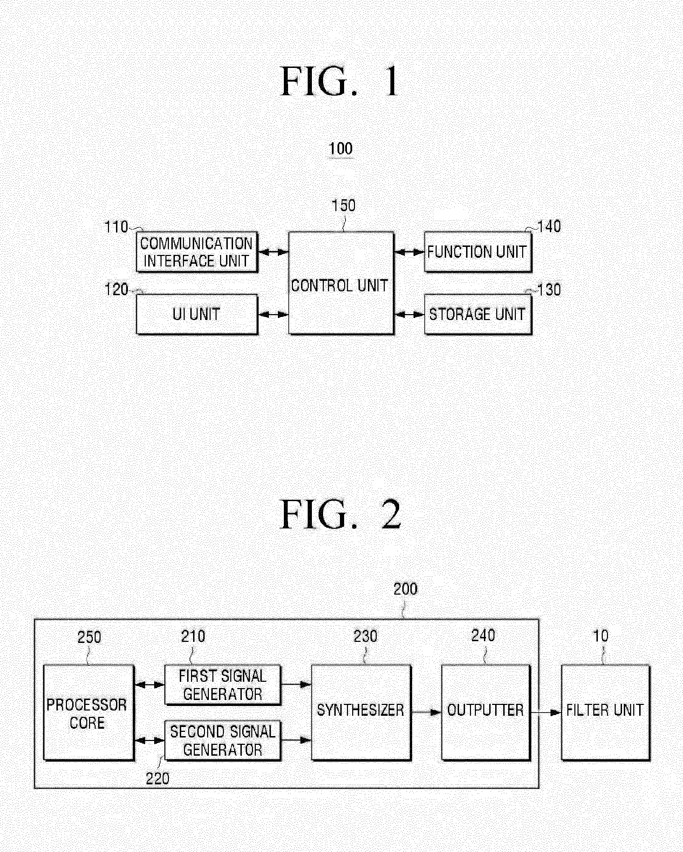

FIG. 1 is a block diagram illustrating an image forming apparatus according to an exemplary embodiment.

Referring to FIG. 1, an image forming apparatus 100 includes a communication interface unit 110, a user interface (UI) unit 120, a storage unit 130, a function unit 140, and a control unit 150.

The communication interface unit 110 may be provided to connect the image forming apparatus 100 to a print control terminal device (not illustrated), for example. For example, the communication interface unit 110 may connect the image forming apparatus 100 to the print control terminal device via a local area network (LAN) or the internet, via a universal serial bus (USB) port, or via a wireless communication method (such as Global System for Mobile Communications (GSM), Universal Mobile Telecommunications System (UMTS), or 3GPP Long Term Evolution (LTE)), for example.

In an embodiment, the communication interface unit 110 may receive job data (for example, print data, or fax data to be transmitted) from the print control terminal device, and may transmit job data generated by the image forming apparatus 100 (for example, scan data, or received fax data) to the print control terminal device.

The UI unit 120 may include a plurality of function keys that allow a user to set or select a variety of functions supported by the image forming apparatus 100, and may display various information provided by the image forming apparatus 100. The UI unit 120 may be implemented as the combination of a monitor and a pointing device such as a mouse or as a device capable of realizing both data input and output, for example, a touch pad. The user may control various functions of the image forming apparatus 100 (for example, a print command, a copy command, a scan command, or a "send fax" command) via a UI window displayed by the UI unit 120.

In an embodiment, the storage unit 130 may store data that may be used for the image forming apparatus 100 to perform its functions. For example, the storage unit 130 may store job data that may be used during the operation of the function unit 140. The storage unit 130 may be implemented as an internal storage medium of the image forming apparatus 100 or as an external storage medium such as a removable disk (for example, a USB memory) or a web server or other internet-based storage medium.

In an embodiment, the function unit 140 may perform various functions of the image forming apparatus 100 such as copying, printing, scanning, and sending or receiving a fax. The function unit 140 may include a copy unit (not illustrated) which performs a copy function, a printing unit (not illustrated) which performs a print function, a scanning unit (not illustrated) which performs a scan function, a fax processing unit (not illustrated) which sends or receives a fax and performs other fax-related functions, and an image processing unit (not illustrated) which converts an image. The function unit 140 may perform the functions of the image forming apparatus 100 in accordance with a first signal output by the control unit 150.

In an embodiment, the control unit 150 may control the communication interface unit 110, the UI unit 120, the storage unit 130, and the function unit 140. More specifically, the control unit 150 may generate a first signal, which is a control signal to control the function unit 140, may generate a second signal, which is a pulse signal having a higher frequency than the first signal, may generate a third signal by synthesizing the first signal and the second signal during an edge period of the first signal, and may transmit the third signal to the function unit 140. The control unit 150 may be implemented as a system-on-chip (SoC) including a processor core, a first signal generator, a second signal generator, a synthesizer, and an outputter. The structure and operation of the control unit 150 are further described with reference to FIG. 2. The term "SoC" indicates, but is not limited to, an integrated circuit that integrates all existing components developed as hardware semiconductor design intellectual property or input/output (I/O) logic, such as semiconductor dies, passive elements, filters, antennas, batters, and the like.

The electromagnetic interference (EMI) properties of the image forming apparatus 100 may be improved by adding a high-frequency pulse signal to a low-frequency signal during an edge period of the low-frequency signal. In addition, since the image forming apparatus 100 may adjust the slew rate of a low-frequency signal without a requirement of a high-capacitance capacitor and a high-resistance resistor, it is possible to reduce the manufacturing cost of the image forming apparatus 100 and the size of a printed circuit board (PCB). Moreover, since the image forming apparatus 100 may adjust the slew rate of a low-frequency signal simply by adjusting the pulse width of a high-frequency signal during the application of a high-frequency pulse signal without a requirement of the modification of hardware, it is possible to reduce the time and effort required to perform debugging during an EMI test.

The exemplary embodiment illustrated in FIG. 1 may be applied not only to an image forming apparatus but also an electronic device equipped with a controller that outputs a low-frequency signal.

FIG. 2 is a block diagram illustrating an example of the control unit 150 illustrated in FIG. 1, according to an exemplary embodiment. Referring to FIG. 2, a control unit 200 includes a first signal generator 210, a second signal generator 220, a synthesizer 230, an outputter 240, and a processor core (or processor) 250.

In an embodiment, the first signal generator 210 may generate a first signal. The first signal may be a low-frequency signal having a frequency of several tens of kHz, for example, a clock signal or a pulse width modulation (PWM) signal to control a motor or a power source.

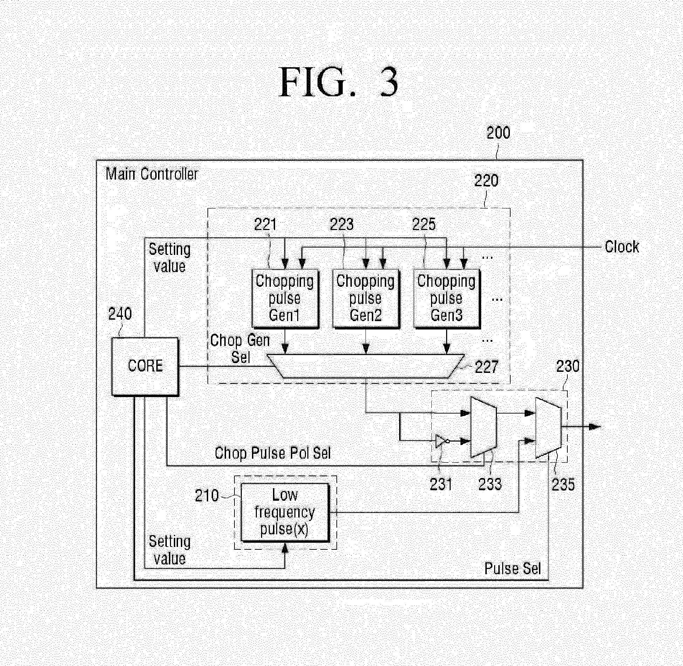

In an embodiment, the second signal generator 220 may generate a second signal, which is a pulse signal having a predefined high frequency. For example, the second signal generator 220 may generate a pulse signal having a frequency of several tens of MHz to several hundreds of MHz. The second signal generator 220 may generate a pulse signal whose duty rate varies. The second signal generator 220 may generate a pulse signal whose duty rate increases closer to the time of the edge of the first signal. The structure and operation of the second signal generator 220 are further described with reference to FIG. 3.

In another embodiment, the first signal generator 210 and the second signal generator 220 may be combined into a signal generator.

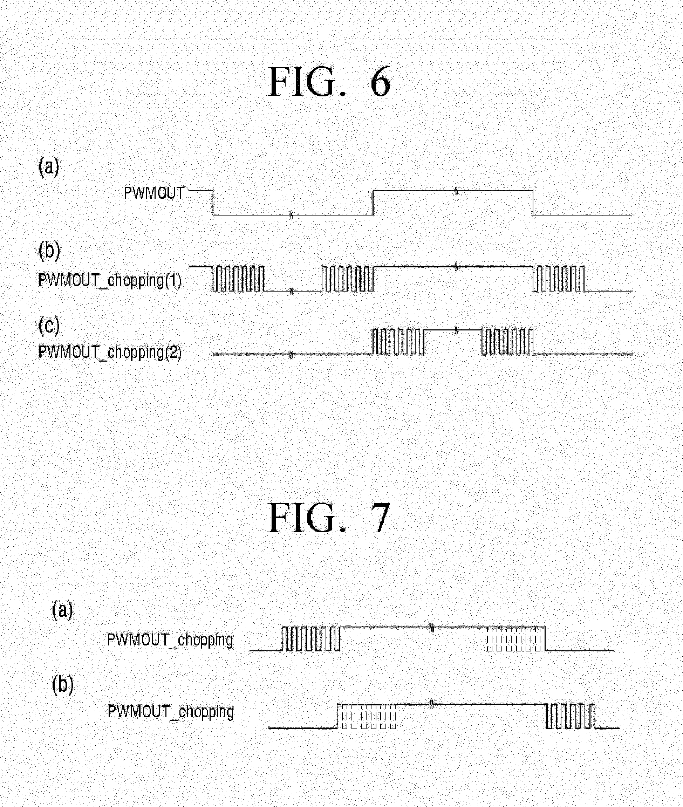

In an embodiment, the synthesizer 230 may generate a third signal by synthesizing the first signal and the second signal during an edge period of the first signal. For example, to improve the slew rate of the first signal, the synthesizer 230 may generate the third signal by synthesizing the first signal and the second signal, which has a high frequency, during a first period that lasts for a predetermined amount of time after the rising edge of the first signal and/or during a second period that lasts for the predetermined amount of time after the falling edge of the first signal. Alternatively, the synthesizer 230 may generate the third signal by synthesizing the first signal and the second signal, which has a high frequency, during a third period that begins the predetermined amount of time before the rising edge of the first signal and ends at the rising edge of the first signal and/or a fourth period that begins the predetermined amount of time before the falling edge of the first signal and ends at the falling edge of the first signal. The first signal and the second signal may be synthesized during one of the first and second periods and one of the third and fourth periods, as illustrated in FIGS. 6(b), 6(c), 7(a) and 7(b).

In an embodiment, the outputter 240 may output the third signal, i.e., the first signal synthesized with the second signal. The outputter 240 may include an output terminal, such as a ped, and may output the first signal synthesized with the second signal via the output terminal. A filter unit 10 may be connected to the output terminal of the outputter 240. The filter unit 10 may be implemented as a resistor-capacitor (RC) or capacitor-resistor (CR) filter. In this exemplary embodiment, a high-frequency pulse signal may be added to the first signal during an edge period of the first signal. Accordingly, a low capacitor and a resistor may be used as the RC Filter or the CR filter, which is connected to the output terminal of the outputter 240.

The RC filter may include a resistor connected in series between the output terminal of the outputter 240 and the function unit 140 and a capacitor connected in parallel to the output terminal of the outputter 240.

In an embodiment, the processor core (processor) 250 may control the first signal generator 210, the second signal generator 220, the synthesizer 230, and the outputter 240. More specifically, the processor core (processor) 250 may control the first signal generator 210 to generate the first signal, which is a low-frequency control signal to control the function unit 140, and may control the second signal generator 220 and the synthesizer 230 to synthesize the first signal and the second signal, which is a high-frequency pulse signal, during an edge period of the first signal.

FIG. 3 is a circuit diagram illustrating an example of the control unit 200, i.e., a control unit 200'.

Referring to FIG. 3, the control unit 200' may include a first signal generator 210, a second signal generator 220, a synthesizer 230, an outputter 240, and a processor core (processor) 250.

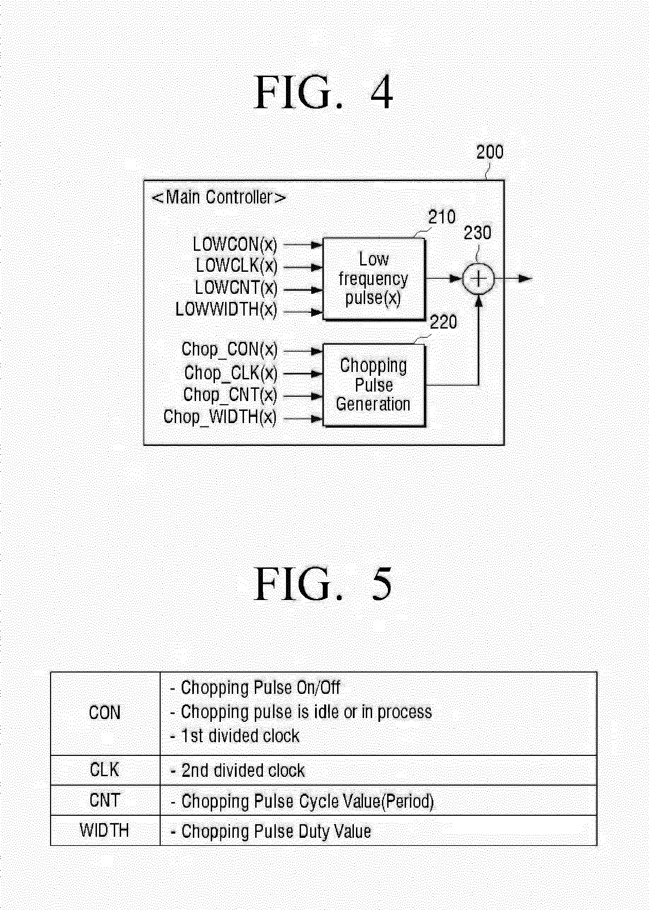

In an embodiment, the first signal generator 210 may receive first setting data including frequency information and phase information relating to a first signal from the processor core (processor) 250, and may generate a first signal, which is a low-frequency signal, based on the first setting data. An example of the first setting data is illustrated in FIG. 4.

In an embodiment, the second signal generator 220 may receive second setting data including frequency information and phase information relating to a second signal from the processor core (processor) 250, and may generate a second signal, which is a high-frequency signal, based on the second setting data. An example of the second setting data is illustrated in FIG. 4. The second signal generator 220 may be configured to include a single chopping pulse generator. Alternatively, referring to FIG. 3, the second signal generator 220 may be configured to include a plurality of chopping pulse generators 221, 223, and 225 and a first multiplexer 227.

Each of the chopping pulse generators 221, 223, and 225 may generate a high-frequency pulse signal based on setting data provided by the processor core (processor) 250, and the high-frequency pulse signals generated by the chopping pulse generators 221, 223, and 225 may have different duty rates. For example, the first chopping pulse generator 221 may generate a pulse signal with a duty rate of approximately 75%, the second chopping pulse generator 223 may generate a pulse signal with a duty rate of approximately 50%, and the third chopping pulse generator 225 may generate a pulse signal with a duty rate of approximately 25%.

The second signal generator 220 is illustrated in FIG. 3 as using only three chopping pulse generators. In another example, the second signal generator 220 may be configured to include a single chopping pulse generator capable of changing the duty rate of a pulse signal or to include two chopping pulse generators or four or more chopping pulse generators.

In an embodiment, the first multiplexer 227 may selectively output one of the pulse signals generated by the chopping pulse generators 221, 223, and 225 to the synthesizer 230. More specifically, the first multiplexer 227 may receive a plurality of pulse signals having different duty rates from the chopping pulse generators 221, 223, and 225, may select a pulse signal whose duty rate increases closer to an edge of the first signal from among the received pulse signals in response to the receipt of a chopping selection signal from the processor core (processor) 250, and may output the selected pulse signal.

In an embodiment, the synthesizer 230 may generate a third signal by synthesizing the first signal and the second signal during an edge period of the first signal. The synthesizer 230 includes an inverter 231, a second multiplexer 233, and a third multiplexer 235.

The inverter 231 may invert an output signal of the second signal generator 220 and may output the inverted output signal.

The second multiplexer 233 may receive the output signal of the second signal generator 220 and the inverted output signal of the second signal generator 220, and may selectively output one of the received signals in accordance with a control signal (Chop Pulse Pol Sel) provided by the processor core (processor) 250.

In an embodiment, the third multiplexer 235 may receive the output signal of the second multiplexer 233 and the first signal generated by the first signal generator 210, and may selectively output one of the first signal and the second signal in accordance with a control signal (Pulse sel) provided by the processor core (processor) 250. More specifically, the third multiplexer 235 may output the second signal along with the first signal during an edge period of the first signal, and may output only the first signal during a non-edge period of the first signal. That is, the third multiplexer 235 may perform a logic OR operation on the first signal and the second signal during the edge period of the first signal, and may perform a logic AND operation on the first signal and the second signal during the non-edge period of the first signal.

The edge period of the first signal may include a period that begins a predetermined amount of time before the rising edge of the first signal and ends at the rising edge of the first signal, and a period that begins from the falling edge of the first signal and lasts for the predetermined amount of time, as illustrated in FIG. 6(b). Alternatively, the edge period of the first signal may include the period that begins from the rising edge of the first signal and lasts for the predetermined amount of time and a period that begins the predetermined amount of time before the falling edge of the first signal and ends at the falling edge of the first signal, as illustrated in FIG. 6(c). Still alternatively, the edge period of the first signal may include the period that begins the predetermined amount of time before the rising edge of the first signal and ends at the rising edge of the first signal and the period that begins the predetermined amount of time before the falling edge of the first signal and ends at the falling edge of the first signal, as illustrated in FIG. 7(a). Still alternatively, the edge period of the first signal may include the period that begins from the rising edge of the first signal and lasts for the predetermined amount of time and the period that begins from the falling edge of the first signal and lasts for the predetermined amount of time, as illustrated in FIG. 7(b). The predetermined amount of time may be determined experimentally. A predetermined count number regarding the second signal (for example, an up/down count of the second signal) may be used, instead of the predetermined amount of time, to determine the edge period of the first signal.

The processor core (processor) 250 may provide various control signals to the first signal generator 210, the second signal generator 220, and the synthesizer 230, and may thus control the first signal generator 210, the second signal generator 220, and the synthesizer 230 to synthesize the first signal and the second signal during the edge period of the first signal.

The first signal generator 210, the second signal generator 220, the synthesizer 230, the outputter 240, and the processor core (processor) 250 are illustrated in FIG. 2 as being parts of the control unit 200. Alternatively, these elements of the control unit 200 may be implemented as a separate apparatus from the image forming apparatus 100, for example, a signal outputting apparatus. The signal outputting apparatus may be an electronic device equipped with a controller that outputs a control signal having a frequency of less than several tens of kHz.

FIGS. 4 and 5 are diagrams illustrating an example of information that may be input to/output from the first signal generator 210 and the second signal generator 220 illustrated in FIG. 2.

Referring to FIG. 4, the first signal generator 210 may receive four control signals from the processor core (processor) 250. An example of the types and functions of the four control signals is illustrated in FIG. 5.

The first signal generator 210 may generate a first signal, which is a low-frequency signal, in accordance with the four control signals, and may output the first signal to the synthesizer 230.

The second signal generator may receive four control signals from the processor core (processor) 250. An example of the types and functions of the four control signals is illustrated in FIG. 5.

The second signal generator 220 may generate a second signal, which is a high-frequency signal, in accordance with the four control signals and may output the second signal to the synthesizer 230.

In the exemplary embodiments illustrated in FIGS. 2 to 4, the first signal generator 210 and the processor core (processor) 250 may be separate elements of the control unit 200. Alternatively, the first signal generator 210 and the processor core (processor) 250 may be incorporated into a single device. For example, the processor core (processor) 250 may be configured to be able to generate a low-frequency signal. In this example, the processor core (processor) 250 may generate the first signal.

FIGS. 6 to 8 are diagrams illustrating various examples of an output signal of a signal outputting apparatus according to an exemplary embodiment.

More specifically, FIG. 6(a) illustrates an example of a first signal, FIGS. 6(b), 6(c), 7(a), 7(b), and 8 illustrate various examples of an output signal of the synthesizer 230.

Referring to FIG. 6, the first signal may be a low-frequency PWM signal to control a motor or a power source.

Referring to FIG. 6(b), a second signal, which is a high-frequency signal, may be added to the first signal during a period that begins a predetermined amount of time before the rising edge of the first signal and ends at the rising edge of the first signal and during a period that begins from the falling edge of the first signal and lasts for the predetermined amount of time.

Alternatively, referring to FIG. 6(c), the second signal may be added to the first signal during a period that begins from the rising edge of the first signal and lasts for the predetermined amount of time and during a period that begins the predetermined amount of time before the falling edge of the first signal and ends at the falling edge of the first signal.

Still alternatively, referring to FIG. 7(a), the second signal may be added to the first signal during the period that begins the predetermined amount of time before the rising edge of the first signal and ends at the rising edge of the first signal and the period that begins the predetermined amount of time before the falling edge of the first signal and ends at the falling edge of the first signal.

Still alternatively, referring to FIG. 7(c), the second signal may be added to the first signal during the period that begins from the rising edge of the first signal and lasts for the predetermined amount of time and the period that begins from the falling edge of the first signal and lasts for the predetermined amount of time.

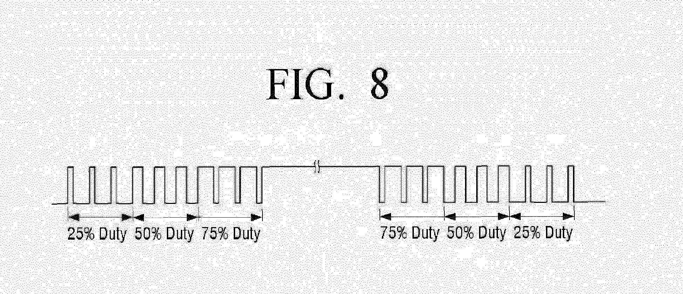

Still alternatively, referring to FIG. 8, a second signal whose duty rate increases closer to the edge period of the first signal may be added to the first signal during the period that begins the predetermined amount of time before the rising edge of the first signal and ends at the rising edge of the first signal and the period that begins from the falling edge of the first signal and lasts for the predetermined amount of time.

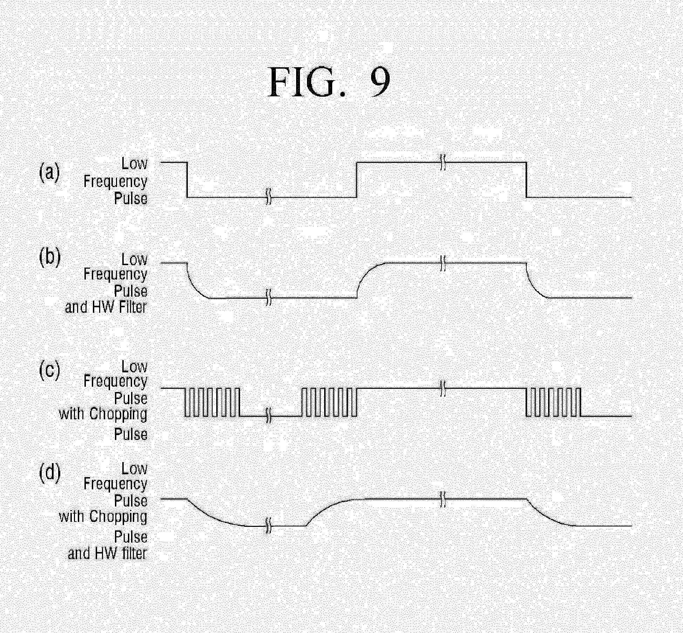

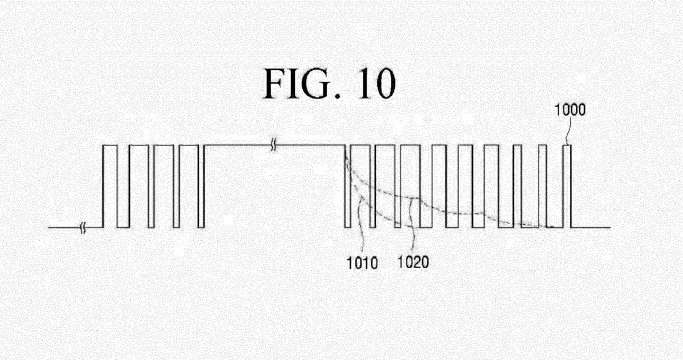

FIGS. 9 and 10 illustrate diagrams illustrating an example of the slew rate of an output signal of a signal outputting apparatus according to an exemplary embodiment.

More specifically, FIG. 9(a) illustrates an example of the waveform of a first signal generated by the first signal generator 210, FIG. 9(b) illustrates an example of the waveform at the output terminal of the outputter 240 in a case in which no second signal is added to the first signal, FIG. 9(c) illustrates an example of the waveform of a signal obtained by adding a second signal to the first signal, and FIG. 9(d) illustrates an example of the waveform at the output terminal of the outputter 240 in a case in which the second signal is added to the first signal.

Referring to FIGS. 9(b) and 9(d), the slew rate of a signal may be higher when the second signal is not added to the first signal than when the second signal is added to the first signal.

FIG. 10 illustrates a waveform diagram obtained by overlapping the waveform diagrams of FIGS. 9(b) and 9(d).

Referring to FIG. 10, when the second signal is not added to the first signal, electric potential 1010 of the output terminal of the outputter 240 may have a high slew rate. On the other hand, when the second signal is added to the first signal, electric potential 1020 of the output terminal of the outputter 240 may have a relatively low slew rate. The dropping of the voltage at the output terminal of the outputter 240 may be delayed during an "ON" period 1000 of the second signal so that the output terminal of the outputter 240 may have a low slew rate.

In some aspects, the filtered output from the outputter 240 has a relatively low slew rate which is determined at least partly by the second signal; rather than the filter unit alone. Thus, the slew rate can be selected by selecting the period or duration of the second signal, instead of requiring use of a high-capacitance capacitor to obtain a low slew rate. A slew rate of the filtered third signal may be lower than a slow rate of the first signal. In some aspects, the filter unit 10 may form a low-pass filter.

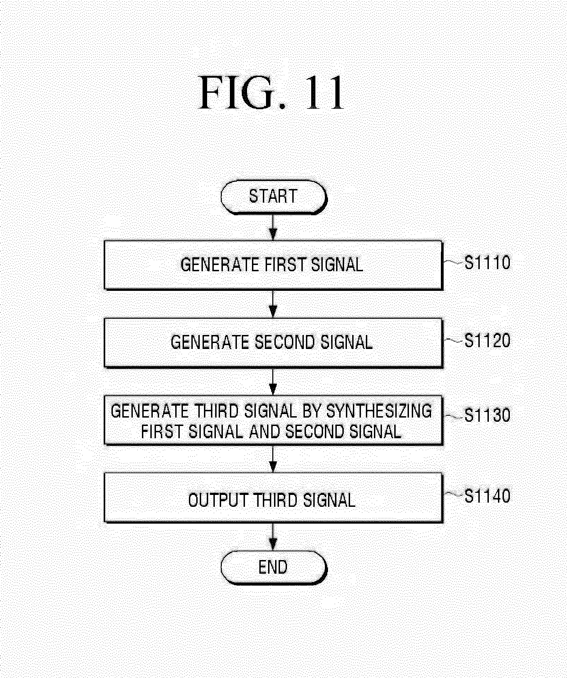

FIG. 11 is a flowchart illustrating a signal outputting method according to an exemplary embodiment.

Referring to FIG. 11, in operation S1110, a first signal may be generated. For example, a low-frequency signal having a frequency of several tens of kHz or lower such as a PWM signal to control a motor or a power source or a clock signal may be generated as the first signal.

In operation S1120, a second signal, which is a pulse signal having a predetermined high frequency, may be generated. For example, a pulse signal having a frequency of several tens of kHz to hundreds of MHz may be generated as the second signal. The duty rate of the second signal may vary over time.

In operation S1130, a third signal may be generated by synthesizing the first signal and the second signal during an edge period of the first signal. For example, the second signal may be output along with the first signal during the edge period of the first signal, and during a non-edge period of the first signal, only the first signal may be output. The edge period of the first signal may include a period that begins a predetermined amount of time before the rising edge of the first signal and ends at the rising edge of the first signal and a period that begins from the falling edge of the first signal and lasts for the predetermined amount of time, as illustrated in FIG. 6(b). Alternatively, the edge period of the first signal may include the period that begins from the rising edge of the first signal and lasts for the predetermined amount of time and a period that begins the predetermined amount of time before the falling edge of the first signal and ends at the falling edge of the first signal, as illustrated in FIG. 6(c). Still alternatively, the edge period of the first signal may include the period that begins the predetermined amount of time before the rising edge of the first signal and ends at the rising edge of the first signal and the period that begins the predetermined amount of time before the falling edge of the first signal and ends at the falling edge of the first signal, as illustrated in FIG. 7(a). Still alternatively, the edge period of the first signal may include the period that begins from the rising edge of the first signal and lasts for the predetermined amount of time and the period that begins from the falling edge of the first signal and lasts for the predetermined amount of time, as illustrated in FIG. 7(b).

In operation S1140, the third signal, i.e., the first signal synthesized with the second signal, may be output.

According to the exemplary embodiment illustrated in FIG. 11, it is possible to improve the EMI properties of an image forming apparatus by adding a high-frequency pulse signal to a low-frequency signal during an edge period of the low-frequency signal. In addition, since the slew rate of the low-frequency signal can be adjusted without the need to use a high-capacitance capacitor and a high-resistance resistor, it is possible to reduce the manufacturing cost of an image forming apparatus and the size of a PCB (printed circuit board). Moreover, since the slew rate of the low-frequency signal can be adjusted by adjusting the period of the application of the high-frequency pulse signal and/or the pulse width of the high-frequency pulse signal, without a requirement of the modification of hardware, it is possible to reduce the time and effort required to perform debugging during an EMI test. The exemplary embodiment illustrated in FIG. ₁₁ may be applied to an image forming apparatus, for example, having the structure illustrated in FIG. 1 or another structure or a signal outputting apparatus, for example, having the structure illustrated in 2 or another structure.

The embodiments can be implemented in computing hardware (computing apparatus) and/or software, such as (in a non-limiting example) any computer that can store, retrieve, process and/or output data and/or communicate with other computers. The results produced can be displayed on a display of the computing hardware. A program/software implementing the embodiments may be recorded on non-transitory computer-readable media comprising computer-readable recording media. Examples of the computer-readable recording media include a magnetic recording apparatus, an optical disk, a magneto-optical disk, and/or a semiconductor memory (for example, RAM, ROM, etc.). Examples of the magnetic recording apparatus include a hard disk device (HDD), a flexible disk (FD), and a magnetic tape (MT). Examples of the optical disk include a DVD (Digital Versatile Disc), a DVD-RAM, a CD-ROM (Compact Disc - Read Only Memory), and a CD-R (Recordable)/RW.

Further, according to an aspect of the embodiments, any combinations of the described features, functions and/or operations can be provided.

The foregoing exemplary embodiments and advantages are merely exemplary and are not to be construed as limiting. The present teaching can be readily applied to other types of apparatuses. Also, the description of the exemplary embodiments is intended to be illustrative, and not to limit the scope of the claims, and many alternatives, modifications, and variations will be apparent to those skilled in the art.

## Claims

1. A signal outputting apparatus comprising:
a first signal generator to generate a first signal comprising a control signal;
a second signal generator to generate a second signal comprising a pulse signal with a predetermined high frequency;
a synthesizer to generate a third signal by synthesizing the first signal and the second signal during an edge period of the first signal; and
an outputter which outputs the third signal.

2. The signal outputting apparatus of claim 1, wherein the first signal comprises at least one of a pulse width modulation (PWM) signal and a clock signal.

3. The signal outputting apparatus of claim 1 or 2, wherein the edge period of the first signal comprises a period that begins from at least one of a rising edge and a falling edge of the first signal and lasts for a predetermined amount of time.

4. The signal outputting apparatus of claim 1 or 2, wherein the edge period of the first signal comprises a period that begins a predetermined amount of time before at least one of a rising edge and a falling edge of the first signal and ends at the at least one of the rising edge and the falling edge of the first signal.

5. The signal outputting apparatus of claim 1 or 2, wherein the edge period of the first signal comprises a period that begins a predetermined amount of time before a rising edge of the first signal and ends at the rising edge of the first signal and a period that begins from a falling edge of the first signal and lasts for the predetermined amount of time.

6. The signal outputting apparatus of claim 1 or 2, wherein the edge period of the first signal comprises a period that begins from a rising edge of the first signal and lasts for a predetermined amount of time and a period that begins the predetermined amount of time before a falling edge of the first signal and ends at the falling edge of the first signal.

7. The signal outputting apparatus of any one of claims 1 to 6, wherein the second signal generator generates a pulse signal whose duty rate varies.

8. The signal outputting apparatus of claim 7, wherein the second signal generator generates a pulse signal whose duty rate increases closer to the edge period of the first signal.

9. An image forming apparatus comprising:
a function unit which performs one or more functions of the image forming apparatus; and
a control unit which controls the function unit to perform the functions of the image forming apparatus, wherein the control unit comprises:
a first signal generator to generate a first signal comprising a control signal for controlling the function unit;
a second signal generator to generate a second signal comprising a pulse signal with a predetermined high frequency;
a synthesizer to generate a third signal by synthesizing the first signal and the second signal during an edge period of the first signal; and
an outputter which outputs the third signal.

10. A signal outputting method of a signal outputting apparatus, comprising:
generating a first signal comprising a control signal;
generating a second signal comprising a pulse signal with a predetermined high frequency;
generating a third signal by synthesizing the first signal and the second signal during an edge period of the first signal; and
outputting the third signal.

11. The signal outputting method of claim 10, wherein the first signal comprises at least one of a PWM signal and a clock signal.

12. The signal outputting method of claim 10 or 11, wherein the edge period of the first signal comprises a period that begins from at least one of a rising edge and a falling edge of the first signal and lasts for a predetermined amount of time.

13. The signal outputting method of claim 10 or 11, wherein the edge period of the first signal comprises a period that begins a predetermined amount of time before at least one of a rising edge and a falling edge of the first signal and ends at the at least one of the rising edge and the falling edge of the first signal.

14. The signal outputting method of claim 10 or 11, wherein the edge period of the first signal comprises a period that begins a predetermined amount of time before a rising edge of the first signal and ends at the rising edge of the first signal and a period that begins from a falling edge of the first signal and lasts for the predetermined amount of time.

15. The signal outputting method of claim 10 or 11, wherein the edge period of the first signal comprises a period that begins from a rising edge of the first signal and lasts for a predetermined amount of time and a period that begins the predetermined amount of time before a falling edge of the first signal and ends at the falling edge of the first signal.
